# EUROPÄISCHE PATENTSCHRIFT

(11) **EP 3 100 344 B1**
(45) Veröffentlichungstag und Bekanntmachung des Hinweises auf die Patenterteilung: **31.03.2021**
(21) Anmeldenummer: 14803133.9
(22) Anmeldetag: 27.11.2014
(51) Int. Cl.: H02M 1/32, H02M 3/335, H02H 7/125, H03K 17/082, B60L 53/20

(54) **BORDNETZTRENNSCHALTUNG FÜR GLEICHSPANNUNGSWANDLER UND VERFAHREN ZUM TRENNEN EINES BORDNETZES VON EINEM GLEICHSPANNUNGSWANDLER**
ON-BOARD ELECTRICAL SYSTEM ISOLATING CIRCUIT FOR DC/DC CONVERTERS, AND METHOD FOR ISOLATING AN ON-BOARD ELECTRICAL SYSTEM FROM A DC/DC CONVERTER
CIRCUIT DE SECTIONNEMENT DE RÉSEAU DE BORD POUR CONVERTISSEUR CONTINU-CONTINU ET PROCÉDÉ DE SECTIONNEMENT D'UN RÉSEAU DE BORD D'AVEC UN CONVERTISSEUR CONTINU-CONTINU

(30) Priorität: 29.01.2014 DE 102014201581
(43) Veröffentlichungstag der Anmeldung: 07.12.2016
(73) Patentinhaber: Robert Bosch GmbH, 70442 Stuttgart (DE)
(72) Erfinder: TRUNK, Martin, 71696 Moeglingen (DE); ROSENBERGER, Marcus, 71701 Schwieberdingen (DE)
(86) Internationale Anmeldenummer: PCT/EP2014/075776
(87) Internationale Veröffentlichungsnummer: WO 2015/113673

(56) Entgegenhaltungen:
- DE-A1-102007 031 494
- DE-A1-102011 076 573
- US-B1- 6 222 742

## Beschreibung

Die Erfindung betrifft eine Bordnetztrennschaltung für einen Gleichspannungswandler, insbesondere für einen Mittelpunktgleichrichter mit Synchrongleichrichtung, sowie ein Verfahren zum Trennen eines Bordnetzes von einem Gleichspannungswandler.

### Stand der Technik

Bei potentialtrennenden Gleichspannungswandlern, beispielsweise zur Versorgung eines Niedervoltbordnetzes eines Fahrzeugs, werden üblicherweise Synchrongleichrichterschaltungen eingesetzt. Die hierzu verwendeten Leistungshalbleiterschalter, beispielsweise MOSFETs, weisen gerade bei höheren Gleichströmen eine geringere Verlustspannung als Dioden auf, wodurch der Wirkungsgrad des Gleichrichters erhöht werden kann.

Im Betrieb der Synchrongleichrichterschaltungen kann es zu Überspannungen an den Leistungshalbleiterschaltern kommen, welche die Leistungshalbleiterschalter überbeanspruchen und in Folge dauerhaft schädigen können. Daher werden üblicherweise Gegenmaßnahmen wie Snubberschaltungen eingesetzt, welche Überspannungen an den Leistungshalbleiterschaltern vermeiden sollen.

Nichtsdestotrotz kann es vorkommen, dass ein Leistungshalbleiterschalter in der Synchrongleichrichterschaltung beschädigt wird und infolgedessen dauerhaft leitend schaltet. In einem derartigen Fall kommt es zu einem unerwünschten Rückstrom vom sekundärseitigen Bordnetz in die Synchrongleichrichterschaltung, wodurch elektrische Energiespeicher des Bordnetzes entladen werden können. Wenn das Bordnetz nicht mehr mit ausreichend Energie versorgt werden kann, können auch bestimmte Fahrzeugkomponenten in ihrer Funktion ausfallen. Aus Sicherheitsgründen ist es daher wünschenswert, derartige Rückströme im Fehlerfall der Synchrongleichrichterschaltung zu unterbinden.

Die Druckschrift DE 41 38 943 C1 beispielsweise offenbart ein Zweispannungsbordnetz, mit einem zwischen den beiden Teilbordnetzen angeordneten Gleichspannungswandler, welcher Bestandteil eines Lade-/Trennmoduls ist, das abhängig von zugeführten Signalen, beispielsweise abhängig von gemessenen Strömen die Verbindung zwischen den beiden Teilbordnetzen unterbricht und so im Fehlerfall Rückwirkungen von einem Teilbordnetz ins andere verhindert.

Die Druckschrift DE 10 2011 076 573 A1 offenbart ein Bordnetzversorgungssystem, mit einem Gleichspannungswandler mit mindestens einem Halbleitergleichrichterelement, zwei Versorgungsanschlüssen für ein Bordnetz, welche ausgangsseitig mit dem Gleichspannungswandler gekoppelt sind, einem Trennschalter, welcher zwischen einen der Versorgungsanschlüsse und den Gleichspannungswandler gekoppelt ist.

Die Druckschrift DE 10 2007 031 494 A1 offenbart eine Energieversorgungssteuerung und betrifft insbesondere die Erkennung eines Kurzschlussfehlers in einem Halbleiterschaltelement. Eine Kurzschlussanomalie des Halbleiterschaltelements wird bestimmt, wenn wenigstens eine Eingangs-zu-Ausgangsspannung des Halbleiterschaltelements kleiner als ein erster Schwellenwert ist.

### Offenbarung der Erfindung

Die vorliegende Erfindung schafft ein Bordnetzversorgungssystem und ein Verfahren zum Trennen eines Bordnetzes von einem Gleichspannungswandler mit den Merkmalen der unabhängigen Patentansprüche.

### Vorteile der Erfindung

Eine Idee der vorliegenden Erfindung ist es, den Rückstrom aus dem Bordnetz über die Messung der Spannung an den Halbleiterelementen des das Bordnetz an das sekundärseitige Netz koppelnden Gleichspannungswandlers zu detektieren. Wenn ein Defekt oder ein Ausfall eines der Halbleiterelemente einen Rückstrom verursacht, kann dies über einen Abfall der Sperrspannung unter eine bestimmte Sperrspannungsschwelle bzw. in einen bestimmten Sperrspannungsbereich erkannt werden. Wenn eine Sperrspannung über eine Mindestdauer in einem kritischen Bereich erkannt wird, der einen Defekt oder Ausfall eines der Halbleiterelemente indiziert, kann die Bordnetztrennschaltung das Bordnetz über einen Trennschalter vom Gleichspannungswandler trennen.

Dadurch kann vorteilhafterweise gewährleistet werden, dass Rückströme vom Bordnetz durch den Gleichspannungswandler wirksam unterbunden werden. Dies verhindert ein Entladen von elektrischen Energiespeichern im Bordnetz und demzufolge einen Ausfall von sicherheitskritischen Bordnetzkomponenten.

Zudem kann auf zusätzliche Sensoren, die einen Rückstrom explizit messen, wie beispielsweise Hallsensoren oder Shuntwiderstände, verzichtet werden. Dies vermindert zum einen die notwendigen Implementierungskosten, zum anderen wird die Leistungseffizienz des Gleichspannungswandlers dadurch nicht geschmälert.

Schließlich ist die Messung der Sperrspannung von Halbleiterelementen des Gleichspannungswandlers gegenüber herkömmlichen Methoden genauer und unabhängiger von der Temperatur des Systems oder fertigungsbedingten Toleranzen.

Gemäß einer Ausführungsform des erfindungsgemäßen Bordnetzversorgungssystems kann der Gleichspannungswandler weiterhin einen Transformator mit einer primärseitigen Wicklung und einer sekundärseitigen Wicklung mit Mittelabgriff, eine Ausgangsinduktivität, welche mit dem Mittelabgriff und einem ersten der Versorgungsanschlüsse verbunden ist; und eine Gleichrichterschaltung mit zwei Halbleitergleichrichterelementen aufweisen, welche jeweils mit den endseitigen Abgriffen der sekundärseitigen Wicklung verbunden sind, und welche zum Erzeugen einer gleichgerichteten Ausgangsspannung an einem zweiten der Versorgungsanschlüsse ausgelegt sind.

Gemäß einer weiteren Ausführungsform des erfindungsgemäßen Bordnetzversorgungssystems können die Halbleitergleichrichterelemente Synchrongleichrichterschalter aufweisen. Gemäß einer alternativen Ausführungsform des erfindungsgemäßen Bordnetzversorgungssystems können die Halbleitergleichrichterelemente Halbleiterdioden aufweisen.

Gemäß einer weiteren Ausführungsform des erfindungsgemäßen Bordnetzversorgungssystems kann das Bordnetzversorgungssystem weiterhin einen Zwischenkreiskondensator aufweisen, welcher zwischen die zwei Versorgungsanschlüsse gekoppelt ist.

Weitere Merkmale und Vorteile von Ausführungsformen der Erfindung ergeben sich aus der nachfolgenden Beschreibung mit Bezug auf die beigefügten Zeichnungen.

### Kurze Beschreibung der Zeichnungen

Es zeigen:
Fig. 1 eine schematische Darstellung eines Bordnetzversorgungssystems mit einem Gleichspannungswandler und einer Bordnetztrennschaltung gemäß einer Ausführungsform der Erfindung;
Fig. 2 eine schematische Darstellung eines Bordnetzversorgungssystems mit einem Gleichspannungswandler und einer Bordnetztrennschaltung gemäß einer weiteren Ausführungsform der Erfindung;
Fig. 3 eine schematische Darstellung eines Bordnetzversorgungssystems mit einem Gleichspannungswandler und einer Bordnetztrennschaltung gemäß einer weiteren Ausführungsform der Erfindung;
Fig. 4 eine schematische Darstellung eines Schaltplans für eine Bordnetztrennschaltung gemäß einer weiteren Ausführungsform der Erfindung;
Fig. 5 eine schematische Darstellung eines Schaltplans für eine Bordnetztrennschaltung gemäß einer weiteren Ausführungsform der Erfindung; und
Fig. 6 eine schematische Darstellung eines Verfahrens zum Trennen eines Bordnetzes von einem Gleichspannungswandler gemäß einer weiteren Ausführungsform der Erfindung.

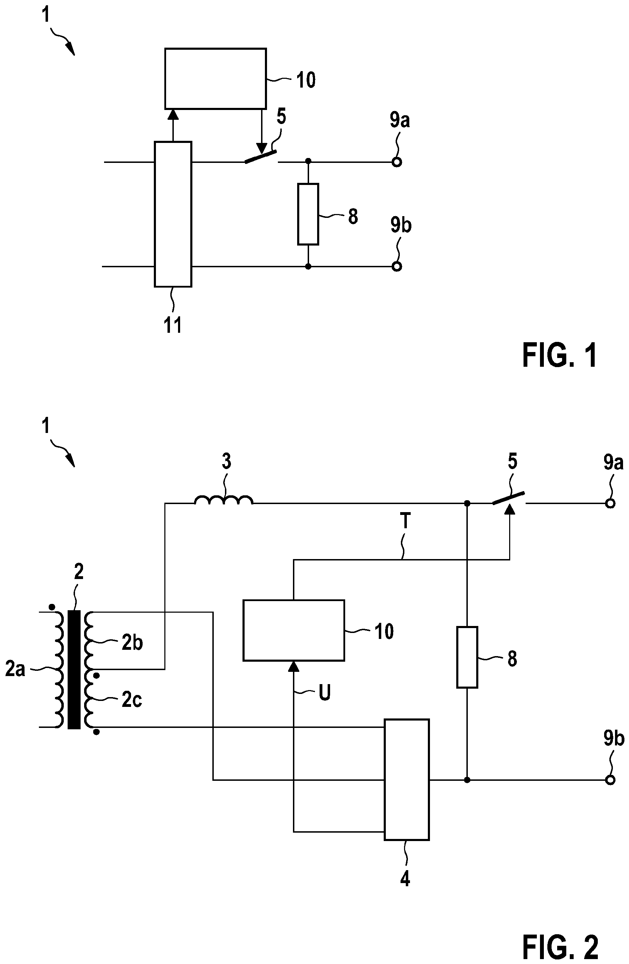

Fig. 1 zeigt eine schematische Darstellung eines Bordnetzversorgungssystems 1 mit einem Gleichspannungswandler 11 und einer Bordnetztrennschaltung 10. Das Bordnetzversorgungssystem 1 kann zum Beispiel in einem elektrisch betreibbaren Fahrzeug, das heißt einem Elektro- oder Hybridfahrzeug, zur Versorgung eines elektrischen Bordnetzes des Fahrzeug eingesetzt. Der Gleichspannungswandler 11 kann eine eingangsseitig eingespeiste Eingangsspannung, beispielsweise aus einem elektrischen Antriebssystem eines Elektro- oder Hybridfahrzeugs, in eine ausgangsseitige Bordnetzsspannung umsetzen, die an zwei Versorgungsanschlüssen 9a, 9b, welche ausgangsseitig mit dem Gleichspannungswandler 11 gekoppelt sind, abgegriffen werden kann. Der Gleichspannungswandler 11 kann mindestens ein Halbleitergleichrichterelement aufweisen, und jede geeignete Wandlertopologie aufweisen, zum Beispiel einen Abwärtswandler, einen Aufwärtswandler, einen Inverswandler, einen Synchronwandler, einen Sperrwandler, einen Gegentaktflusswandler oder einen Resonanzwandler. Zwischen die zwei Versorgungsanschlüsse 9a, 9b kann zur Spannungsglättung ein Zwischenkreiselement 8, beispielsweise ein Zwischenkreiskondensator 8 geschaltet sein.

Zudem weist das Bordnetzversorgungssystem 1 einen Trennschalter 5 auf, welcher zwischen einen der Versorgungsanschlüsse 9a, 9b und den Gleichspannungswandler 11 gekoppelt ist. Der Trennschalter 5 kann beispielsweise ein Halbleiterschalter sein, zum Beispiel ein Feldeffekttransistor (FET). Es ist jedoch ebenso möglich, andere Halbleiterschalter in entsprechender Form als Trennschalter 5 vorzusehen, zum Beispiel in Form eine IGBT (Insulated Gate Bipolar Transistor). Das Bordnetzversorgungssystem 1 verfügt über eine Bordnetztrennschaltung 10, welche dazu ausgelegt ist, eine Sperrspannung an zumindest einem der Halbleitergleichrichterelemente des Gleichspannungswandlers 11 zu ermitteln. Die Bordnetztrennschaltung 10 überprüft die ermittelte Sperrspannung und erzeugt in Abhängigkeit vom Wert der ermittelten Sperrspannung ein Ansteuersignal für den Trennschalter 5, um das an den zwei Versorgungsanschlüssen 9a, 9b angekoppelte Bordnetz vom Gleichspannungswandler 11 abzutrennen.

Die Bordnetztrennschaltung 10 kann dabei die Sperrspannung(en) beispielsweise überwachen, indem die Sperrspannung(en) mit einer maximalen Auslöseschwelle verglichen werden. Wenn die Sperrspannung(en) für eine minimale Vergleichszeit, beispielsweise 7 µs oder mehr, unterhalb der maximalen Auslöseschwelle, welche zum Beispiel im Bereich zwischen 1 V und 2 V liegen kann, liegt, kann davon ausgegangen werden, dass das betreffende Halbleitergleichrichterelement bzw. die betreffenden Halbleitergleichrichterelemente defekt sind. Dann kann die Bordnetztrennschaltung 10 ein Ansteuersignal für den Trennschalter 5 ausgeben, um das Bordnetz vom Gleichspannungswandler 11 zu trennen.

Bei intakten Halbleitergleichrichterelementen ist die Sperrspannung üblicherweise kleiner als 0 V, solange der Halbleiter in Dioden-Flussrichtung leitet. Wenn der Halbleiter vom leitenden in den sperrenden Zustand übergeht, übersteigt die Sperrspannung rasch die maximale Auslöseschwelle und liegt auf einem Spannungswert, der beispielsweise gleich groß wie oder größer als die Bornetzspannung ist.

Zur Verbesserung der Erkennungsgenauigkeit kann die Bordnetztrennschaltung 10 die Sperrspannung(en) beispielsweise auch dahingehend überwachen, ob die Sperrspannung(en) eine minimale Auslöseschwelle unterschreiten werden. Wenn die Sperrspannung(en) für eine minimale Vergleichszeit, beispielsweise 7 µs oder mehr, überhalb der minimalen Auslöseschwelle, beispielsweise 0 V, und unterhalb der maximalen Auslöseschwelle, zum Beispiel im Bereich zwischen 1 V und 2 V, liegt, kann davon ausgegangen werden, dass das betreffende Halbleitergleichrichterelement bzw. die betreffenden Halbleitergleichrichterelemente defekt sind.

Der Gleichspannungswandler ist im Beispiel der Fig. 2 als Gegentaktflusswandler ausgestaltet und umfasst einen Transformator 2 mit einer primärseitigen Wicklung 2a und einer sekundärseitigen Wicklung, welche über einen Mittelabgriff in zwei Abschnitte 2b und 2c geteilt ist. Der Transformator 2 kann beispielsweise zur Wandlung einer Hochvoltspannung in eine Niedervoltspannung ausgelegt sein und zum Beispiel ein Wicklungsverhältnis zwischen primärseitiger und sekundärseitiger Wicklung von über Eins aufweisen, insbesondere beispielsweise 10:1. Das Wicklungsverhältnis der beiden sekundärseitigen Wicklungsabschnitte 2b und 2c kann dabei insbesondere Eins betragen, das heißt, die beiden sekundärseitigen Wicklungsabschnitte 2b und 2c besitzen gleiche Wicklungszahl.

Auf der Primärseite 2a des Transformators 2 kann zum Beispiel eine Hochspannungsquelle mit einem daran angeschlossenen Wechselrichter in Vollbrückenschaltung zur Wandlung der Gleichspannung der Hochspannungsquelle in eine Hochvoltwechselspannung angekoppelt werden.

Der Mittelabgriff des Transformators 2 ist über eine sekundärseitige Induktivität 3 mit einem ersten Ausgangsanschluss 9a verbunden. Die beiden endseitigen Abgriffe der jeweiligen sekundärseitigen Wicklungsabschnitte 2b und 2c sind mit zwei Eingängen einer Gleichrichterschaltung 4 verbunden. Die Gleichrichterschaltung 4 kann beispielsweise einen Synchrongleichrichter mit aktiven Schaltelementen aufweisen. Es kann jedoch auch möglich sein, die Gleichrichterschaltung 4 mit passiven Schaltelementen auszugestalten. Der Gleichspannungswandler kann somit eine Mittelpunktsgleichrichterschaltung mit passiver oder aktiver Gleichrichtung umfassen.

Die Gleichrichterschaltung 4 ist dazu ausgelegt, von den endseitigen Abgriffen der jeweiligen sekundärseitigen Wicklungsabschnitte 2b und 2c eine an dem Transformator 2 sekundärseitig anliegende Spannung abzugreifen und über eine geeignete Verschaltung in eine Gleichspannung an einem zweiten Ausgangsanschluss 9b zu wandeln. Mit anderen Worten, während des Betriebs des Gleichspannungswandlers ist zwischen den Ausgangsanschlüssen 9a und 9b eine Ausgangsgleichspannung abgreifbar.

Zwischen dem ersten und dem zweiten Ausgangsanschluss 9a, 9b kann ferner ein Gleichspannungszwischenkreis 8 vorgesehen sein, welcher zur Spannungsglättung dienen kann. Der Gleichspannungszwischenkreis 8 kann beispielsweise einen Zwischenkreiskondensator oder eine andere Gleichspannungsquelle wie zum Beispiel eine Batterie oder einen Akkumulator aufweisen.

Die Bordnetztrennschaltung 10 kann beispielsweise in einem Mikroprozessor implementiert werden und eine Sperrspannung U an zumindest einem der Halbleitergleichrichterelemente der Gleichrichterschaltung 4 ermitteln. Falls die ermittelte Sperrspannung in einem Bereich liegt, in dem auf einen Ausfall oder einen Defekt eines der Halbleitergleichrichterelemente der Gleichrichterschaltung 4 geschlossen werden kann, kann die Bordnetztrennschaltung 10 ein Ansteuersignal T an den Trennschalter 5 zum Abkoppeln des Bordnetzes vom Gleichspannungswandler ausgeben.

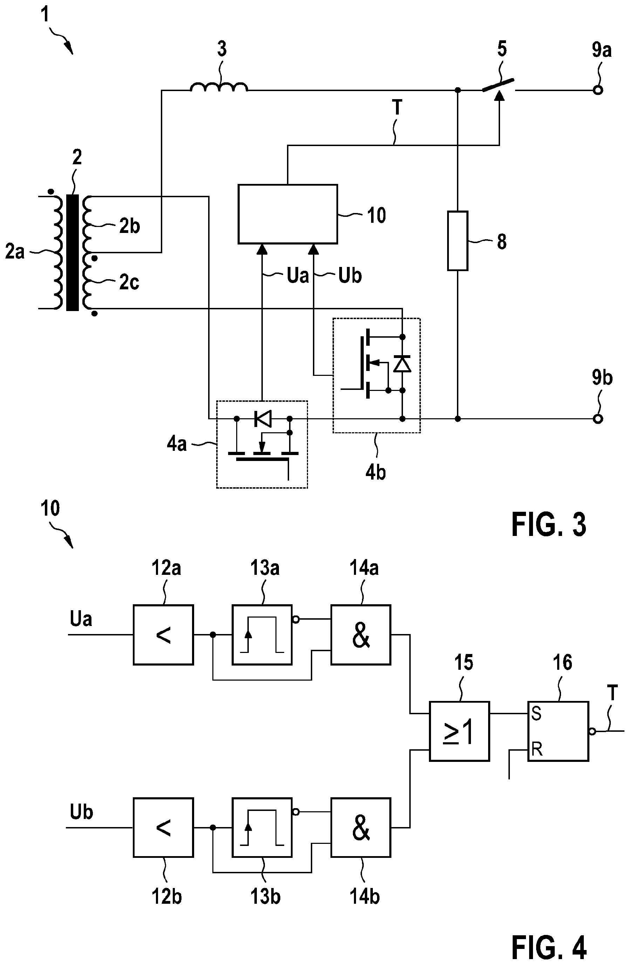

Fig. 3 zeigt ein Bordnetzversorgungssystem mit einem Gleichspannungswandler und einer Bordnetztrennschaltung 10 gemäß einer weiteren Ausführungsform. Der Gleichspannungswandler der Fig. 3 unterscheidet sich von dem Gleichspannungswandler 1 in Fig. 2 im Wesentlichen durch den höheren Detailgrad der dargestellten Bauelemente.

Die Synchrongleichrichterschaltung 4 ist in Fig. 3 durch zwei Synchrongleichrichterschalter 4a und 4b realisiert. Jeder der Synchrongleichrichterschalter 4a, 4b weist dabei ein aktives Schaltelement und eine dazu parallel geschaltete Freilaufdiode auf. Es ist dabei klar, dass die Freilaufdiode bei Verwendung von Halbleiterschaltern, beispielsweise MOSFET-Schaltern, die parasitische Diode des aktiven Schaltelements selbst sein kann.

Die verwendeten Synchrongleichrichterschalter 4a, 4b können dabei jeweils Halbleiterschalter, wie beispielsweise Feldeffekttransistoren (FETs) aufweisen. In den gezeigten Ausführungsformen sind die Halbleiterschalter jeweils als selbstsperrende n-MOSFETs (n-leitende Metal Oxide Semiconductor Field-Effect Transistors, Anreicherungstyp) dargestellt, es ist jedoch ebenso möglich, andere Halbleiterschalter in entsprechender Form vorzusehen, zum Beispiel in Form von IGBTs (Insulated Gate Bipolar Transistors), JFETs (Junction Field-Effect Transistors) oder als p-MOSFETs (p-leitende Metal Oxide Semiconductor Field-Effect Transistors).

Alternativ können statt der Synchrongleichrichterschalter 4a, 4b auch passive Halbleiterbauelemente wie beispielsweise Halbleiterdioden eingesetzt werden, um eine passive Gleichrichterschaltung 4 zu realisieren.

Die Bordnetztrennschaltung 10 misst die Sperrspannungen Ua und Ub der Synchrongleichrichterschalter 4a, 4b und erzeugt bei erkannten Defekt oder Ausfall eines der beiden Synchrongleichrichterschalter 4a, 4b das Ansteuersignal T für das Trennen des Bordnetzes vom Gleichspannungswandler mittels des Trennschalters 5.

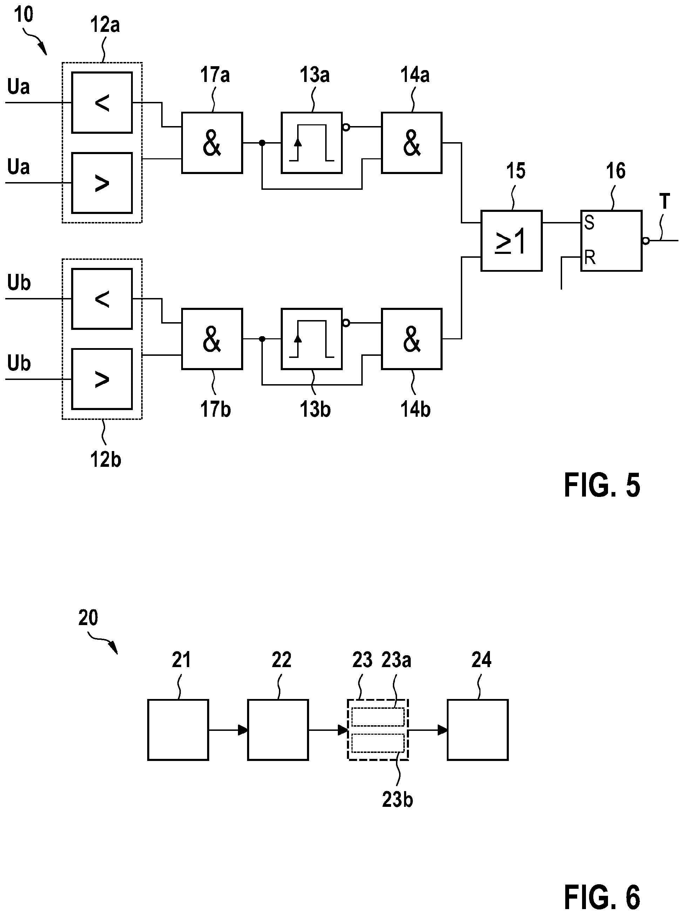

Die Fig. 4 und 5 zeigen beispielhafte Implementierungen für eine logische Schaltung zur Überwachung der Sperrspannungen Ua und Ub in der Bordnetztrennschaltung 10. Die ermittelten Werte Ua bzw. Ub für die Sperrspannungen der einzelnen Halbleitergleichrichterelemente der Gleichrichterschaltung 4 werden in Vergleicher 12a und 12b eingespeist, welche dazu ausgelegt sind, ein Unterschreiten eines ersten Schwellwerts bzw. erster Schwellwerte für die Sperrspannungen der Halbleitergleichrichterelemente zu ermitteln. Das Vergleichersignal wird über einen Vergleichszeittrigger 13a, 14a bzw. 13b, 14b in eine Oder-Schaltung 15 eingespeist, so dass, wenn einer der beiden Vergleichersignale über einen durch den Vergleichszeittrigger gesteuerten Mindestzeitraum hinweg unterhalb des ersten Schwellwerts liegt, ein Flip-Flp 16 geschaltet wird, welcher in Abhängigkeit Vergleichersignals des Vergleichers 12a, 12b, ein Ansteuersignal für den Trennschalter 5 ausgeben kann.

Wie in Fig. 5 beispielhaft gezeigt, kann der Vergleicher 12a bzw. 12b weiterhin dazu ausgelegt sein, zu ermitteln, ob die Sperrspannung(en) Ua bzw. Ub der Halbleitergleichrichterelemente der Gleichrichterschaltung 4 einen zweiten Schwellwert überschreitet. Nur wenn in einer Und-Schaltung 17a bzw. 17b ermittelt wird, dass die Sperrspannung(en) Ua bzw. Ub der Halbleitergleichrichterelemente der Gleichrichterschaltung 4 über einen Mindestvergleichszeitraum hinweg zwischen den zweiten Schwelllwert und dem ersten Schwellwert, beispielsweise zwischen 0 V und etwa 1 V bis 2 V liegen, wird am Flip-Flop 16 das entsprechende Ansteuersignal T zum Trennen des Bordnetzes vom Gleichspannungswandler gesetzt.

Fig. 6 zeigt ein beispielhaftes Verfahren 20 zum Trennen eines Bordnetzes von einem Gleichspannungswandler, beispielsweise dem Gleichspannungswandler 11 im Bordnetzversorgungssystem der Fig. 1 bis 3. Das Verfahren 20 umfasst in einem ersten Schritt 21 ein Umrichten einer Versorgungsspannung mit einem Gleichspannungswandler 11 in eine Bordnetzspannung. In einem zweiten Schritt wird eine Sperrspannung an zumindest einem der Halbleitergleichrichterelemente des Gleichspannungswandlers 11 ermittelt.

Optional kann dann in Teilschritt 23a des Schritts 23 ein Überprüfen erfolgen, ob die ermittelte Sperrspannung einen ersten Schwellwert unterschreitet. Ebenso kann in Teilschritt 23b des Schritts 23 ein Überprüfen erfolgen, ob die ermittelte Sperrspannung einen zweiten Schwellwert überschreitet. In Abhängigkeit von dem Überprüfen kann in Schritt 24 dann ein Trennschalter 5 zum Abkoppeln des Bordnetzes vom Gleichspannungswandler 11 in Abhängigkeit vom Wert der ermittelten Sperrspannung erfolgen.

## Patentansprüche

1. Bordnetzversorgungssystem (1), mit:
einem Gleichspannungswandler (11) mit mindestens einem Halbleitergleichrichterelement (4);
zwei Versorgungsanschlüssen (9a, 9b) für ein Bordnetz, welche ausgangsseitig mit dem Gleichspannungswandler (11) gekoppelt sind; und
einem Trennschalter (5), welcher zwischen einen der Versorgungsanschlüsse (9a, 9b) und den Gleichspannungswandler (11) gekoppelt ist;
**gekennzeichnet durch**
eine Bordnetztrennschaltung (10), welche dazu ausgelegt ist, eine Sperrspannung (U; Ua; Ub) an zumindest einem der Halbleitergleichrichterelemente (4) zu ermitteln, und in Abhängigkeit von einem Wert der ermittelten Sperrspannung (U; Ua; Ub) den Trennschalter (5) zum Abkoppeln des Bordnetzes vom Gleichspannungswandler (11) anzusteuern,
wobei die Bordnetztrennschaltung (10) aufweist:
einen Vergleicher (12a; 12b), welcher dazu ausgelegt ist, ein Unterschreiten einer ersten Schwellwerts für die Sperrspannung (Ua; Ub) der Halbleitergleichrichterelemente (4) zu ermitteln und zu ermitteln, ob die Sperrspannung (Ua; Ub) der Halbleitergleichrichterelemente (4) einen zweiten Schwellwert überschreitet;
einen Flip-Flop (16), welcher dazu ausgelegt ist, in Abhängigkeit von einem Ausgangssignal des Vergleichers (12a; 12b) ein Ansteuersignal (T) für den Trennschalter (5) auszugeben; und
einen Vergleichstrigger (13a, 14a, 13b, 14b, 15), der dazu ausgelegt ist, den Flip-Flip (16) zu schalten, wenn mindestens eine der ermittelten Sperrspannungen (Ua; Ub) über einen Mindestvergleichszeitraum hinweg zwischen dem zweiten Schwelllwert und dem ersten Schwellwert liegt.

2. Bordnetzversorgungssystem (1) nach Anspruch 1, wobei der Gleichspannungswandler (11) aufweist:
einen Transformator (2) mit einer primärseitigen Wicklung (2a) und einer sekundärseitigen Wicklung (2b, 2c) mit Mittelabgriff;
einer Ausgangsinduktivität (3), welche mit dem Mittelabgriff und einem ersten der Versorgungsanschlüsse (9a) verbunden ist; und
eine Gleichrichterschaltung (4) mit zwei Halbleitergleichrichterelementen (14a, 14b), welche jeweils mit den endseitigen Abgriffen der sekundärseitigen Wicklung (2b, 2c) verbunden sind, und welche zum Erzeugen einer gleichgerichteten Ausgangsspannung an einem zweiten der Versorgungsanschlüsse (9b) ausgelegt sind.

3. Bordnetzversorgungssystem (1) nach Anspruch 2, wobei die
Halbleitergleichrichterelemente (14a, 14b) Synchrongleichrichterschalter aufweisen.

4. Bordnetzversorgungssystem (1) nach Anspruch 2, wobei die
Halbleitergleichrichterelemente (14a, 14b) Halbleiterdioden aufweisen.

5. Bordnetzversorgungssystem (1) nach einem der Ansprüche 1 bis 4, weiterhin mit:
einem Zwischenkreiskondensator (8), welcher zwischen die zwei Versorgungsanschlüsse (9a, 9b) gekoppelt ist.

6. Verfahren (20) zum Trennen eines Bordnetzes von einem Gleichspannungswandler (11), mit den Schritten:
Umrichten (21) einer Versorgungsspannung mit einem Gleichspannungswandler (11) in eine Bordnetzspannung;
**gekennzeichnet durch**
Ermitteln (22) einer Sperrspannung (U; Ua; Ub) an zumindest einem der Halbleitergleichrichterelemente (4) des Gleichspannungswandlers (11);
Überprüfen (23a), ob die ermittelte Sperrspannung (U; Ua; Ub) einen ersten Schwellwert unterschreitet;
Überprüfen (23b), ob die ermittelte Sperrspannung (U; Ua; Ub) einen zweiten Schwellwert überschreitet; und
Ansteuern (24) eines Trennschalters (5) zum Abkoppeln des Bordnetzes vom Gleichspannungswandler (11) in Abhängigkeit vom Wert der ermittelten Sperrspannung (U; Ua; Ub);
wobei der Trennschalter (5) angesteuert wird, wenn mindestens eine der ermittelten Sperrspannungen (Ua; Ub) über einen Mindestvergleichszeitraum hinweg zwischen dem zweiten Schwelllwert und dem ersten Schwellwert liegt.

## Claims

1. On-board electrical system supply system (1), comprising:
a DC/DC converter (11) having at least one semiconductor rectifier element (4);
two supply terminals (9a, 9b) for an on-board electrical system, which are coupled to the DC/DC converter (11) on the output side; and
an isolating switch (5) coupled between one of the supply terminals (9a, 9b) and the DC/DC converter (11);
**characterized by**
an on-board electrical system isolating circuit (10) designed to determine a reverse voltage (U; Ua; Ub) at at least one of the semiconductor rectifier elements (4) and to drive the isolating switch (5) for decoupling the on-board electrical system from the DC/DC converter (11) depending on a value of the determined reverse voltage (U; Ua; Ub),
wherein the on-board electrical system isolating circuit (10) comprises:
a comparator (12a; 12b) designed to determine an undershooting of a first threshold value for the reverse voltage (Ua; Ub) of the semiconductor rectifier elements (4) and to determine whether the reverse voltage (Ua; Ub) of the semiconductor rectifier elements (4) exceeds a second threshold value;
a flip-flop (16) designed to output a drive signal (T) for the isolating switch (5) depending on an output signal of the comparator (12a; 12b); and
a comparison trigger (13a, 14a, 13b, 14b, 15) designed to switch the flip-flop (16) when at least one of the determined reverse voltages (Ua; Ub) is between the second threshold value and the first threshold value over a minimum comparison time interval.

2. On-board electrical system supply system (1) according to Claim 1, wherein the DC/DC converter (11) comprises:
a transformer (2) having a primary-side winding (2a) and a secondary-side winding (2b, 2c) with a centre tap;
an output inductance (3), which is connected to the centre tap and a first of the supply terminals (9a); and
a rectifier circuit (4) having two semiconductor rectifier elements (14a, 14b), which are respectively connected to the end-side taps of the secondary-side winding (2b, 2c) and which are designed for generating a rectified output voltage at a second of the supply terminals (9b).

3. On-board electrical system supply system (1) according to Claim 2, wherein the semiconductor rectifier elements (14a, 14b) comprise synchronous rectifier switches.

4. On-board electrical system supply system (1) according to Claim 2, wherein the semiconductor rectifier elements (14a, 14b) comprise semiconductor diodes.

5. On-board electrical system supply system (1) according to any of Claims 1 to 4, furthermore comprising:
an intermediate circuit capacitor (8) coupled between the two supply terminals (9a, 9b).

6. Method (20) for isolating an on-board electrical system from a DC/DC converter (11), comprising the following steps:
converting (21) a supply voltage into an on-board electrical system voltage by means of a DC/DC converter (11) ;
**characterized by**
determining (22) a reverse voltage (U; Ua; Ub) at at least one of the semiconductor rectifier elements (4) of the DC/DC converter (11);
checking (23a) whether the determined reverse voltage (U; Ua; Ub) undershoots a first threshold value;
checking (23b) whether the determined reverse voltage (U; Ua; Ub) exceeds a second threshold value; and
driving (24) an isolating switch (5) for decoupling the on-board electrical system from the DC/DC converter (11) depending on the value of the determined reverse voltage (U; Ua; Ub);
wherein the isolating switch (5) is driven when at least one of the determined reverse voltages (Ua; Ub) is between the second threshold value and the first threshold value over a minimum comparison time interval.

## Revendications

1. Système d'alimentation de réseau de bord (1), ledit système comprenant :
un convertisseur de tension continue (11) pourvu d'au moins un élément redresseur à semi-conducteur (4) ;
deux bornes d'alimentation (9a, 9b) destinées à un réseau de bord et montées du côté sortie au convertisseur de tension continue (11) ; et
un disjoncteur (5) qui est monté entre l'une des bornes d'alimentation (9a, 9b) et le convertisseur de tension continue (11) ;
**caractérisé par**
un circuit de disjonction de réseau de bord (10) qui est conçu pour déterminer une tension de blocage (U ; Ua ; Ub) sur l'un au moins des éléments redresseurs à semi-conducteurs (4), et pour commander, en fonction d'une valeur de la tension de blocage (U ; Ua ; Ub) déterminée, le disjoncteur (5) afin de déconnecter le réseau de bord du convertisseur de tension continue (11),
le circuit de disjonction de réseau de bord (10) comportant :
un comparateur (12a ; 12b) qui est conçu pour déterminer si la tension de blocage (Ua ; Ub) des éléments redresseurs à semi-conducteurs (4) devient inférieure à une première valeur de seuil et pour déterminer si la tension de blocage (Ua ; Ub) des éléments redresseurs à semi-conducteurs (4) devient supérieure à une deuxième valeur de seuil ;
une bascule bistable (16) qui est conçue pour délivrer un signal de commande (T) destiné au disjoncteur (5) en fonction d'un signal de sortie du comparateur (12a ; 12b) ; et
un déclencheur de comparaison (13a, 14a, 13b, 14b, 15) qui est conçu pour commuter la bascule bistable (16) lorsqu'au moins une des tensions de blocage déterminées (Ua ; Ub) est située entre la deuxième valeur de seuil et la première valeur de seuil au-delà d'un intervalle de temps de comparaison minimum.

2. Système d'alimentation de réseau de bord (1) selon la revendication 1, le convertisseur de tension continue (11) comportant :
un transformateur (2) pourvu d'un enroulement côté primaire (2a) et d'un enroulement côté secondaire (2b, 2c) avec prise centrale ;
une inductance de sortie (3) qui est reliée à la prise centrale et à une première des bornes d'alimentation (9a) ; et
un circuit redresseur (4) pourvu de deux éléments redresseurs à semi-conducteurs (14a, 14b) qui sont reliés chacun aux prises côté extrémité de l'enroulement côté secondaire (2b, 2c) et qui sont conçus pour générer une tension de sortie redressée à une deuxième des bornes d'alimentation (9b).

3. Système d'alimentation de réseau de bord (1) selon la revendication 2, les éléments redresseurs à semi-conducteurs (14a, 14b) comportant des commutateurs de redresseur synchrones.

4. Système d'alimentation de réseau de bord (1) selon la revendication 2, les éléments redresseurs à semi-conducteurs (14a, 14b) comportant des diodes à semi-conducteurs.

5. Système d'alimentation de réseau de bord (1) selon l'une des revendications 1 à 4, comprenant en outre :
un condensateur de circuit intermédiaire (8) qui est monté entre les deux bornes d'alimentation (9a, 9b).

6. Procédé (20) de disjonction d'un réseau de bord d'un convertisseur de tension continue (11), le procédé comprenant les étapes suivantes :
convertir (21) une tension d'alimentation au moyen d'un convertisseur de tension continue (11) en une tension de réseau de bord ;
**caractérisé par** les étapes suivantes
déterminer (22) une tension de blocage (U ; Ua ; Ub) sur l'un au moins des éléments redresseurs à semi-conducteurs (4) du convertisseur de tension continue (11) ;
vérifier (23a) si la tension de blocage déterminée (U ; Ua ; Ub) devient inférieure à une première valeur de seuil ;
vérifier (23b) si la tension de blocage (U ; Ua ; Ub) déterminée devient supérieure à une deuxième valeur de seuil ; et
commander (24) un disjoncteur (5) pour déconnecter le réseau de bord du convertisseur de tension continue (11) en fonction de la valeur de la tension de blocage (U ; Ua ; Ub) déterminée ;
le disjoncteur (5) étant commandé lorsqu'au moins une des tensions de blocage déterminées (Ua ; Ub) est située entre la deuxième valeur de seuil et la première valeur de seuil pendant un intervalle de temps de comparaison minimum.
